# EUROPÄISCHE PATENTSCHRIFT

(11) **EP 0 998 184 B1**
(45) Veröffentlichungstag und Bekanntmachung des Hinweises auf die Patenterteilung: **01.12.2004**
(21) Anmeldenummer: 99121335.6
(22) Anmeldetag: 26.10.1999
(51) Int. Cl.: H05K 13/08

(54) **Verfahren zum Handhaben von Bauteilen mittels eines Handhabungsgerätes und Handhabungsgerät zur Durchführung des Verfahrens**
Manipulator and method for manipulating components
Manipulateur et méthode pour manipuler des composants

(30) Priorität: 28.10.1998 DE 19849689
(43) Veröffentlichungstag der Anmeldung: 03.05.2000
(73) Patentinhaber: ROBERT BOSCH GMBH, 70442 Stuttgart (DE)
(72) Erfinder: Petereit, Steffen, Dipl.-Ing., 70499 Stuttgart (DE); Schilling, Ulrich, Dipl.-Ing., 70567 Stuttgart (DE)

(56) Entgegenhaltungen:
- US-A- 5 471 310

## Beschreibung

### Stand der Technik

Die Erfindung betrifft ein Verfahren zum Handhaben von Bauteilen mittels eines mit optischem System, Mehrkoordinaten Stelleinrichtung und Greifer versehenen Handhabungsgerätes, bei dem das optische System und der Greifer eine mittels der Mehrkoordinaten-Stelleinrichtung verstellbare Einheit bilden und der Greifer selbst an dieser Einheit zusätzlich verstellbar ist sowie ein Handhabungsgerät zur Durchführung des Verfahrens.

In der Mikroelektronik und in der Mikrosystemtechnik ist es in zunehmendem Maße erforderlich, Bauteile mit hoher Genauigkeit relativ zu einem Werkstück zu positionieren. Dazu müssen die verwendeten Handhabungsgeräte durch eine geeignete Systemanordnung und die Auswahl entsprechender Komponenten eine möglichst hohe Präzision aufweisen. Zudem ist es in der Regel erforderlich, dass die Lage des zu montierenden Bauteils im Greifer des Handhabungsgerätes exakt vermessen werden kann. So lassen sich Ungenauigkeiten erfassen und ausgleichen, wie sie bei der Aufnahme des Bauteils, z.B. von einem Blue-Tape oder aus einem Gurt, entstehen können. Die insgesamt bei der Montage resultierende Genauigkeit wird dann durch die Positioniergenauigkeit des Greifers bestimmt.

Ein bekanntes Verfahren für die Bauteilvermessung im Greifer, das z.B. für die Bestückung von gehäusten Chips in der SMD-Technik eingesetzt wird, besteht darin, die Lage des Bauteils im Greifer mit einer zweiten zusätzlichen Kamera zu erfassen. Dazu wird der Greifer mit dem Bauteil über die zweite Kamera bewegt und das Bauteil von unten vermessen.

Ein anderes bekanntes Verfahren beruht darauf, das Bauteil im Greifer mit Licht aus einer definierten Richtung zu beleuchten. Der dabei entstehende Schatten wird von einem Detektor, z.B. von einer Photodiodenzelle, erfaßt.

Bei beiden bekannten Verfahren wird die Lage des Bauteils anhand seiner Außenkanten bestimmt. Bei ungehäusten Chips, sogenannten Dies, ergibt sich dadurch die Schwierigkeit, dass die Außenkanten der Dies aufgrund des üblicherweise zur Chipvereinzelung verwendeten Sägeprozesses deutlich größere Toleranzen als die auf der Oberseite photolithographisch angebrachten, funktionellen Strukturen aufweisen. Ähnliches gilt für Mikrobauteile, wie sie z.B. in der Mikrosystemtechnik eingesetzt werden.

Für eine hochpräzise Die-Montage muß deshalb anstelle der Außenkanten die Oberseite der Dies vermessen werden. Gängige Verfahren hierfür bestimmen zunächst vor der Bauteilaufnahme die Lage der Strukturen relativ zu den Außenkanten. Nach der Aufnahme des Dies wird dann seine Lage im Greifer anhand der Außenkanten erfaßt. Mit der zuvor gewonnenen Information läßt sich daraus rechnerisch auf die Lage der Oberflächenstrukturen relativ zum Greifer schließen. Andere Verfahren vermessen die Oberfläche des gegriffenen Chips direkt von oben, z.B. durch den Greifer hindurch bzw. neben der Greiffläche. Soll eine einzelne Kamera sowohl zur Bauteilbetrachtung im Greifer als auch zur Vermessung der Zielposition auf dem Werkstück dienen, dann ist es erforderlich, die Schärfeebene der Kamera zu verändern. Dies kann entweder durch eine Änderung der Objektweite des Kameraobjektives (Zoom-Objektiv) oder aber durch eine zusätzliche Verstellmöglichkeit der Kamera relativ zum Greifer (zweite z-Achse) erfolgen. Beides für einerseits zu einem erhöhten Aufwand und damit zu höheren Kosten für das Handhabungsgerät, andererseits wird durch die zusätzlichen Bewegungsachsen die Systemgenauigkeit prinzipiell vermindert. Die gleichzeitige Beobachtung von Werkstück und Bauteil ist in der Regel nicht möglich, da die Schärfentiefe von hochauflösenden Objektiven prinzipbedingt gering ist und oft nur einige Mikrometer beträgt.

Es ist Aufgabe der Erfindung, ein Verfahren der eingangs erwähnten Art zu schaffen, mit dem die Beobachtung eines Bauteils im Greifer mit einem einzigen optischen System präzise und kostengünstig durchgeführt werden kann, um so die bei der Teileaufnahme enstandenen Positionstoleranzen ausgleichen zu können.

Diese Aufgabe wird nach der Erfindung dadurch gelöst, dass das optische System der Einheit mit Festbrennweite ausgelegt wird, dass der Greifer zwischen dem optischen System und seiner Fokusebene angeordnet und zu Beginn des Handhabungsablaufes in eine Arbeitsposition eingestellt wird, in der seine Greiferebene einen Arbeitsabstand zur Fokusebene einnimmt, dass die Einheit mit dem in Arbeitsposition befindlichen Greifer in Aufnahmerichtung so weit verstellt und ausgerichtet wird, bis das aus einer Aufnahmeebene aufzunehmende Bauteil in der Fokusebene scharf erkennbar und greifbar ist, dass die Einheit danach in Richtung zur Aufnahmeebene verstellt wird und der Greifer unter Überfederung und Ausweichen in Richtung zum optischen System auf das Bauteil aufgesetzt wird, dass das Bauteil gegriffen und die Einheit entgegen der Aufnahmerichtung von der Aufnahmeebene abgehoben wird, dass der Greifer dabei in eine Betrachtungsposition gebracht wird, in der seine Greiferebene mit der Fokusebene zusammenfällt, dass nach dem Vermessen des Bauteils in der Betrachtungsposition in die Arbeitsposition zurückgestellt wird, dass die Einheit über das Werkstück verstellt und auf das zu bestückende Werkstück positioniert wird, wobei die Fokusebene mit der Werkstückebene zur Deckung gebracht werden, dass das Fügen des Bauteils in gleicher Weise wie das Aufnehmen des Bauteils durchgeführt wird. Dabei kann nach einer weiteren Ausgestaltung nach dem Fügen des Bauteils der Greifer geöffnet und für einen neuen Handhabungsablauf wieder in die Arbeitsposition gebracht werden.

Mit diesem Verfahren ist es möglich, das vom Greifer gegriffene Bauteil im Greifer zu vermessen, ohne dabei zusätzliche Bewegungsachsen einführen zu müssen. Es beruht auf dem bei der Chipmontage üblicherweise angewandten Konstruktionsprinzip, den Greifer relativ zum Achssystem der Mehrkoordinaten-Stelleinrichtung zu überfedern. Der Greifer und damit auch das gegriffene Bauteil sind also relativ zu der Einheit aus optischem System verschiebbar. Diese Überfederung ist erforderlich, um beim Aufsetzen des Greifers bei der Aufnahme des Bauteils bzw. beim Fügen des Bauteils auf dem Werkstück Positioniertoleranzen zuzulassen und definierte Kräfte sicherzustellen. Eine Zerstörung der Fügepartner wird dadurch verhindert. Das Überfedern muß bei präzisen Montageanlagen mit entsprechend präzisen Führungen realisiert sein, da Abweichungen direkt als Fehler in die Positionierung eingehen. Diese Führungen werden in der Regel nur zum Überfedern aus der Arbeitsposition verwendet, also aus der Ebene, von der aus der Greifer auf das Bauteil bzw. Werkstück aufgesetzt wird. Die Verstellung erfolgt dabei stets mittels der Mehrkoordinaten-Stelleinrichtung. Durch entsprechende Verlängerung des Hubs der Überfederung ist es möglich, den Greifer und damit das Bauteil über dem als Kamera mit Bildauswerteeinrichtung ausgebildeten optischen System aus der Arbeitsposition heraus um den benötigten Betrag abzusenken, so dass sich das Bauteil mit seiner Oberseite in der Fokusebene des optischen Systems befindet. Als Führungselemente werden diejenigen verwendet, die auch für die Überfederung, d.h. die Verstellung in Richtung zum optischen System, vorhanden sind, so dass hier keine weiteren Bewegungsachsen erforderlich sind. Im Gegensatz zu den bekannten Verfahren entsteht beim erfindungsgemäßen Verfahren im Greifer weder ein erhöhter Kostenaufwand, noch wird durch zusätzliche Bewegungsachsen die Präzision verringert.

Das vom Greifer gegriffene Bauteil wird in der Stellung der Einheit vermessen, in der die Greiferebene = Oberfläche des Bauteils = mit der Fokusebene zusammenfällt.

Die Aufnahme- und Fügerichtung sind vorzugsweise gleich ausgerichtet und werden in die z-Achse der Mehrkoordinaten-Stelleinrichtung gelegt.

Der Greifer kann zudem in eine Ausgangsposition eingestellt werden, aus der er nur in Richtung zur Fokusebene - in die Arbeitsposition und in die Bauteil-Beobachtungsposition - eingestellt werden kann.

Die Absenkung des Greifers in die Fokusachse kann nach einer Ausgestaltung durch einen Anschlag begrenzt werden, der auch verstellbar an der Einheit angebracht werden kann. Dasselbe gilt auch für die Einstellung der Arbeitsposition des Greifers.

Um eine exakte Einstellung zu erhalten, kann auch vorgesehen sein, dass die Absenkung der Greiferebene in die Arbeitsposition und/oder in die Fokusebene mittels eines durch ein Meßsystem gesteuerten Elektromotors ausgeführt wird.

Ein Handhabungsgerät zur Durchführung des Verfahrens ist dadurch gekennzeichnet, dass das optische System und der Träger des Greifers eine Einheit bilden, die mittels der Mehrkoordinaten-Stelleinrichtung in der Aufnahme- und Fügerichtung verstellbar ist, dass das optische System eine Festbrennweite aufweist, dass der Greifer zwischen dem optischen System und seiner Fokusebene in eine Ausgangs-, eine Arbeits- und eine Beobachtungsposition an der Einheit im Strahlengang einstellbar ist, dass in der Ausgangsposition der Greifer eine dem optischen System zugekehrte Endstellung mit einem ersten großen Arbeitsabstand zur Fokusebene einnimmt, dass die Arbeitsposition zwischen dieser Endstellung und der Fokusebene liegt und in Richtung zum optischen System abgefedert ist und dass in der Beobachtungsposition die Greiferebene mit der Fokusebene zusammenfällt, wobei der Greifer zumindest im Bereich des Strahlenganges lichtdurchlässig ist.

Weiterbildungen des Handhabungsgerätes sind den Unteransprüchen zu entnehmen.

Das erfindungsgemäße Verfahren wird anhand eines in den Zeichnungen dargestellten Ausführungsbeispiels näher erläutert. Es zeigen jeweils im Schnitt:
- Fig. 1: einen Greifer in der Ausgangsposition RP an einer Einheit aus optischem System und Mehrkoordinaten-Stelleinrichtung,
- Fig. 2: den Greifer in der zu Beginn eines Handhabungsablaufes eingestellten Arbeitsposition AP und
- Fig. 3: den Greifer in der in die Fokusebene abgesenkten Bauteil-Betrachtungsposition BP.

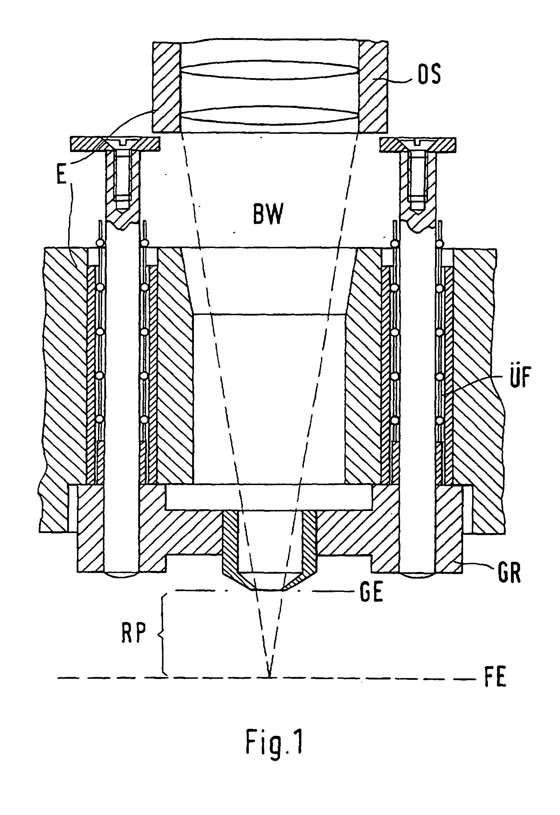

Das optische System OS des Handhabungsgerätes ist in den Fig. 1 bis 3 nur als Objektiv einer Kamera mit der Festbrennweite BW und dem Strahlengang zur Fokusebene FE dargestellt. Die Mehrkoordinaten-Stelleinrichtung, der eigentliche Kamerateil und die Bildauswerteeinrichtung samt der Steuerung für das Handhabungsgerät sind nicht dargestellt, da diese in bekannter Weise ausgelegt sein können und funktionieren. Zu erwähnen ist lediglich, dass das Aufnahmeteil für die Überfederung ÜF und die Kamera eine Einheit E bilden, die mit der Mehrkoordinaten-Stelleinrichtung gemeinsam verstellbar ist.

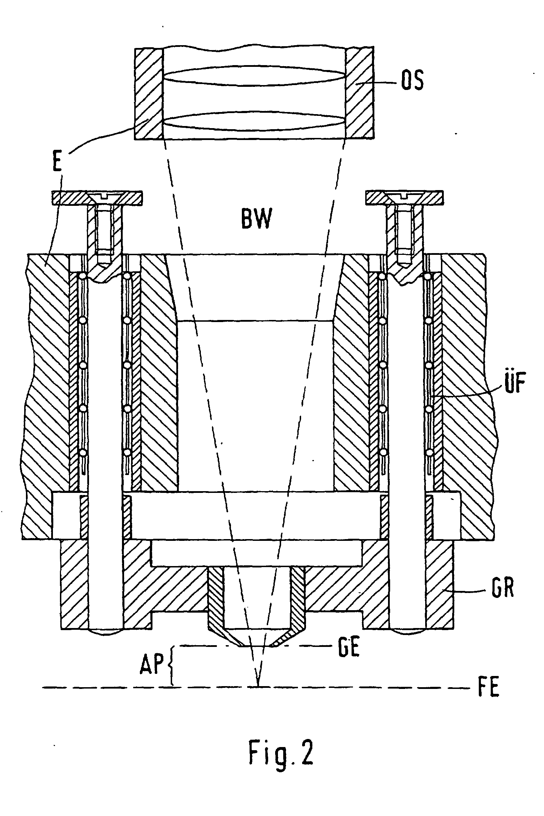

Wie Fig. 1 zeigt, kann der Greifer GR in eine Ausgangsposition RP gebracht werden, in der er einen ausreichend großen Arbeitsabstand zur Fokusebene FE einnimmt. Der Greifer GR kann mittels der als Überfederung ÜF bezeichneten Verstelleinrichtung an der Einheit E in Richtung zur Fokusebene FE verstellt werden. Soll ein Handhabungsablauf zum Aufnehmen und Greifen sowie anschließendem Fügen eines Bauteils auf einem Werkstück ausgeführt werden, dann wird zu Beginn der Greifer GR in eine Arbeitsposition AP gebracht, wie Fig. 2 zeigt. Der Greifer GR hat mit seiner Greiferebene GE, die z.B. durch die Saugöffnung des als Sauggreifer ausgebildeten Greifers GR gegeben ist, nur einen kleineren Abstand zur Fokusebene FE.

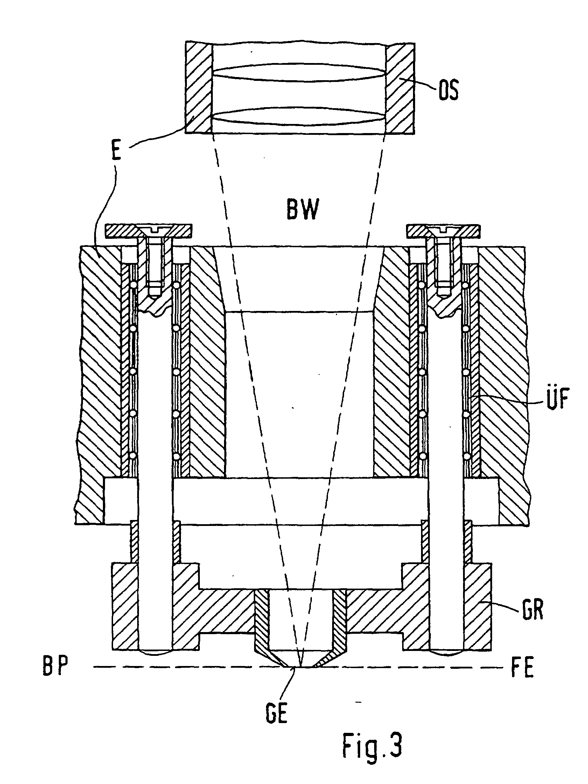

In bekannter Weise wird der Greifer GR über das aufzunehmende Bauteil gebracht, das in einer bestimmten Zielposition angeboten wird. Der nach Fig. 2 in die Arbeitsposition AP gebrachte Greifer GR erlaubt die Betrachtung des Bauteils in der Zielposition, wenn die Mehrkoordinaten-Stelleinrichtung hier in z-Richtung die Einheit E soweit verstellt, dass das aufzunehmende Bauteil in der Fokusebene FE klar und scharf erkennbar ist. Der Greifer GR kann zum Aufnehmen des Bauteils ausgerichtet werden, behält jedoch seine Arbeitsposition AP im Abstand zur Fokusebene FE bei. Danach wird die Einheit E mit dem in Arbeitspositionen AP gehaltenen Greifer GR auf das Bauelement abgesenkt. Dabei wird die Stellbewegung über den z-Antrieb der Mehrkoordinaten-Stelleinrichtung vorgenommen, bis der Greifer GR auf dem Bauteil aufgesetzt ist. Dabei wird der Greifer GR entgegen der Überfederung ÜF in Richtung zum optischen System OS angehoben. Eine Beobachtung des Bauteils ist zu diesem Zeitpunkt nicht möglich, da die Greiferebene GE nun mehr oder weniger über der Fokusebene FE liegt. Die Oberseite des Bauteils liegt näher am optischen System OS. In dieser Zwischenstellung wird das Bauteil gegriffen. Hebt die Einheit E danach durch entgegengesetzt gerichtete Verstellung von der Zielebene mit den angebotenen Bauteilen genügend ab, dann kann der Greifer GR über die Überfederung ÜF in die Beobachtungsposition BP nach Fig. 3 verstellt werden. Die Greiferebene GE kommt dann mit der Fokusebene FE zur Deckung, so dass das Bauteil scharf über das optische System OS abgebildet ist und vermessen werden kann. Ist die Vermessung erfolgt, dann wird der Greifer GR in die Arbeitsposition AP nach Fig. 2 zurückgestellt. Die Einheit E wird über das zu bestückende Werkstück bewegt und zwar über die Mehrkoordinaten-Stelleinrichtung. Dabei wird in z-Richtung die Einstellung so vorgenommen, dass das Werkstück scharf abgebildet ist, d.h. die Fokusebene FE ist mit der Werkstückebene zur Deckung gebracht. Das Bauteil ist in dieser Einstellung nicht zu beobachten. Das Fügen des Bauteils auf dem Werkstück erfolgt wie beim Aufnehmen von der Aufnahmeebene durch Überfederung aus der Arbeitsposition AP des Greifers GR. Der Greifer GR öffnet und gibt das gefügte Bauteil frei. Abschließend wird der Greifer GR wieder in die Arbeitsposition AP gebracht und steht für einen neuen Handhabungsablauf bereit.

In jedem Fall ist das optische System mit seinem Strahlengang in die Aufnahmeund Fügeeinrichtung ausgerichtet. In der Regel ist dies die z-Richtung der Mehrkoordinaten-Stelleinrichtung. Die Ausrichtung und Verstellung kann auch in einer anderen Richtung erfolgen. Aufnahme- und Fügerichtung können auch unterschiedlich sein. Der Verfahrensablauf bleibt davon unberührt. Lediglich die Positionierung und die Verstellbewegungen sind anzupassen.

Ein Handhabungsgerät zur Durchführung des Verfahrens ist nach einer Ausgestaltung dadurch gekennzeichnet, dass das optische System und der Träger des Greifers eine Einheit bilden, die mittels der Mehrkoordinaten-Stelleinrichtung in der Aufnahme- und Fügerichtung verstellbar ist, dass das optische System eine Festbrennweite aufweist, dass der Greifer zwischen dem optischen System und seiner Fokusebene in eine Ausgangs-, eine Arbeits- und eine Beobachtungsposition an der Einheit im Strahlengang einstellbar ist, dass in der Ausgangsposition der Greifer eine dem optischen System zugekehrte Endstellung mit einem ersten großen Arbeitsabstand zur Fokusebene einnimmt, dass die Arbeitsposition zwischen dieser Endstellung und der Fokusebene liegt und in Richtung zum optischen System abgefedert ist und dass in der Beobachtungsposition die Greiferebene mit der Fokusebene zusammenfällt, wobei der Greifer zumindest im Bereich des Strahlenganges lichtdurchlässig ist. Dabei besteht der Greifer GR nach einer vorteilhaften Ausbildung aus Glas oder glasklarem Kunststoff und ist als Sauggreifer ausgebildet. Dann kann das gegriffene Bauteil in der Beobachtungsposition BP vermessen werden.

Die Einstellung der Arbeitsposition AP und der Beobachtungsposition BP wird durch Anschläge an der Einheit E erleichtert, die vorzugsweise verstell- und arretierbar sind.

Um eine Beschädigung oder Zerstörung des aus der Aufnahmeebene aufzunehmenden und in der Werkstückebene abzugebenden Bauteils zu vermeiden, ist vorgesehen, dass der Greifer in der Arbeitsposition mittels einer Überfederung in der Einheit in Richtung zum optischen System hin abgefedert ist.

## Patentansprüche

1. Verfahren zum Handhaben von Bauteilen mittels eines mit optischem System, Mehrkoordinaten-Stelleinrichtung und Greifer versehenen Handhabungsgerätes, bei dem das optische System und der Greifer eine mittels der Mehrkoordinaten-Stelleinrichtung verstellbare Einheit bilden und der Greifer selbst an dieser Einheit zusätzlich verstellbar ist,
**dadurch gekennzeichnet,**
**dass** das optische System (OS) der Einheit (E) mit Festbrennweite (BW) ausgelegt wird,
**dass** der Greifer (GR) zwischen dem optischen System (OS) und seiner Fokusebene (FE) angeordnet und zu Beginn des Handhabungsablaufes in eine Arbeitsposition (AP) eingestellt wird, in der seine Greiferebene (GE) einen Arbeitsabstand zur Fokusebene (FE) einnimmt,
**dass** die Einheit (E) mit dem in Arbeitsposition (AP) befindlichen Greifer (GR) in Aufnahmerichtung so weit verstellt und ausgerichtet wird, bis das aus einer Aufnahmeebene aufzunehmende Bauteil in der Fokusebene (FE) scharf erkennbar und greifbar ist,
**dass** die Einheit (E) danach in Richtung zur Aufnahmeebene verstellt wird und der Greifer (GR) auf das Bauteil aufgesetzt wird,
**dass** das Bauteil gegriffen und die Einheit (E) entgegen der Aufnahmerichtung von der Aufnahmeebene abgehoben wird,
**dass** der Greifer (GR) dabei in eine Betrachtungsposition (BP) gebracht wird, in der seine Greiferebene (GE) mit der Fokusebene (FE) zusammenfällt,
**dass** nach dem Vermessen des Bauteils in der Betrachtungsposition (BP) in die Arbeitsposition (AP) zurückgestellt wird,
**dass** die Einheit (E) über das Werkstück verstellt und auf das zu bestückende Werkstück positioniert wird, wobei die Fokusebene (FE) mit der Werkstückebene zur Deckung gebracht werden, und
**dass** das Fügen des Bauteils in gleicher Weise wie das Aufnehmen des Bauteils durchgeführt wird.

2. Verfahren nach Anspruch 1,
**dadurch gekennzeichnet,**
**dass** nach dem Fügen des Bauteils der Greifer (GR) geöffnet und für einen neuen Handhabungsablauf wieder in die Arbeitsposition (AP) gebracht wird.

3. Verfahren nach Anspruch 1,
**dadurch gekennzeichnet,**
**dass** das optische System (OS) mit einer Kamera und einer Bildauswerteeinrichtung versehen ist.

4. Verfahren nach einem der Ansprüche 1 bis 3,
**dadurch gekennzeichnet,**
**dass** das vom Greifer (GR) gegriffene Bauteil in der Stellung der Einheit (E) vermessen wird, in der die Greiferebene (GE) mit der Fokusebene (FE) zusammenfällt.

5. Verfahren nach einem der Ansprüche 1 bis 4,
**dadurch gekennzeichnet,**
**dass** die Aufnahme- und die Fügerichtung vorzugsweise gleich ausgerichtet und in die z-Achse der Mehrkoordinaten-Stelleinrichtung gelegt werden.

6. Verfahren nach einem der Ansprüche 1 bis 5,
**dadurch gekennzeichnet,**
**dass** der Greifer (GR) in eine Ausgangsposition (RP) eingestellt wird, aus der er nur in Richtung zur Fokusebene (FE) verstellbar ist.

7. Verfahren nach einem der Ansprüche 1 bis 6,
**dadurch gekennzeichnet,**
**dass** die Absenkung der Greiferebene (GE) in die Arbeitsposition (AP) und/oder in die Fokusebene (FE) mittels eines Anschlages begrenzt wird.

8. Verfahren nach Anspruch 7,
**dadurch gekennzeichnet,**
**dass** der Anschlag an der Einheit (E) verstellbar angebracht ist.

9. Verfahren nach einem der Ansprüche 1 bis 6,
**dadurch gekennzeichnet,**
**dass** die Absenkung der Greiferebene (GE) in die Arbeitsposition (AP) und/oder in die Fokusebene (FE) mittels eines durch ein Meßsystem gesteuerten Elektromotors ausgeführt wird.

10. Handhabungsgerät zur Durchführung des Verfahrens nach einem oder mehreren der Ansprüche 1 bis 9,
**dadurch gekennzeichnet,**
**dass** das optische System (OS) und der Träger des Greifers (GR) eine Einheit (E) bilden, die mittels der Mehrkoordinaten-Stelleinrichtung in der Aufnahme- und Fügerichtung verstellbar ist,
**dass** das optische System (OS) eine Festbrennweite (BW) aufweist,
**dass** der Greifer (GR) zwischen dem optischen System (OS) und seiner Fokusebene (FE) in eine Ausgangs- (RP), eine Arbeits- (AP) und eine Beobachtungsposition (BP) an der Einheit (E) im Strahlengang einstellbar ist, dass in der Ausgangsposition (RP) der Greifer (GR) eine dem optischen System (OS) zugekehrte Endstellung mit einem ersten großen Arbeitsabstand zur Fokusebene (FE) einnimmt,
**dass** die Arbeitsposition (AP) zwischen dieser Endstellung und der Fokusebene (FE) liegt und in Richtung zum optischen System (OS) abgefedert ist und
**dass** in der Beobachtungsposition (BP) die Greiferebene (GE) mit der Fokusebene (FE) zusammenfällt, wobei der Greifer (GR) zumindest im Bereich des Strahlenganges lichtdurchlässig ist.

11. Handhabungsgerät nach Anspruch 10,
**dadurch gekennzeichnet,**
**dass** der Greifer (GR) aus Glas oder glasklarem Kunststoff besteht und als Sauggreifer ausgebildet ist.

12. Handhabungsgerät nach Anspruch 10 und 11,
**dadurch gekennzeichnet,**
**dass** die Ausgangsposition (RP) und die Beobachtungsposition (BP) durch vorzugsweise verstell- und arretierbare Anschläge der Einheit (E) vorgegeben sind.

13. Handhabungsgerät nach einem der Ansprüche 10 bis 12,
**dadurch gekennzeichnet,**
**dass** der Greifer (GR) in der Arbeitsposition (AP) mittels einer Überfederung (ÜF) in der Einheit (E) in Richtung zum optischen System OS) hin abgefedert und durch Druck auf die Greiferebene (GE) auslenkbar ist.

## Claims

1. Method for manipulating components by means of a manipulator provided with an optical system, multi-coordinate positioning device and gripper, in which the optical system and the gripper form a unit that can be adjusted by means of the multi-coordinate positioning device and the gripper itself can additionally be adjusted on this unit,
**characterized**
**in that** the optical system (OS) of the unit (E) is designed with a fixed focal length (BW),
**in that** the gripper (GR) is arranged between the optical system (OS) and its focal plane (FE) and, at the start of the manipulation sequence, is adjusted into a working position (AP), in which its gripper plane (GE) assumes a working distance from the focal plane (FE),
**in that** the unit (E) with the gripper (GR) in the working position (AP) is displaced and aligned in a pick-up direction until the component to be picked up from a pick-up plane can be detected sharply in the focal plane (FE) and can be gripped,
**in that** the unit (E) is then displaced in the direction of the pick-up plane and the gripper (GR) is then placed on the component,
**in that** the component is gripped and the unit (E) is raised from the pick-up plane in the direction opposite to the pick-up direction,
**in that**, in the process, the gripper (GR) is moved into a viewing position (BP), in which its gripper plane (GE) coincides with the focal plane (FE),
**in that**, after the component has been measured in the viewing position (BP), it is reset into the working position (AP),
**in that** the unit (E) is displaced over the workpiece and is positioned on the workpiece to be populated, the focal plane (FE) being brought into coincidence with the workpiece plane, and
**in that** the joining of the component is carried out in the same way as picking up the component.

2. Method according to Claim 1, **characterized in that**, following the joining of the component, the gripper (GR) is opened and brought into the working position (AP) again for a new manipulation sequence.

3. Method according to Claim 1, **characterized in that** the optical system (OS) is provided with a camera and an image evaluation device.

4. Method according to one of Claims 1 to 3, **characterized in that** the component gripped by the gripper (GR) is measured in the position of the unit (E) in which the gripper plane (GE) coincides with the focal plane (FE).

5. Method according to one of Claims 1 to 4, **characterized in that** the pick-up direction and the joining direction are preferably aligned in the same direction and are placed in the z-axis of the multi-coordinate positioning device.

6. Method according to one of Claims 1 to 5, **characterized in that** the gripper (GR) is adjusted into a starting position (RP) from which it can be displaced only in the direction of the focal plane (FE).

7. Method according to one of Claims 1 to 6, **characterized in that** the lowering of the gripper plane (GE) into the working position (AP) and/or into the focal plane (FE) is limited by means of a stop.

8. Method according to Claim 7, **characterized in that** the stop is fitted to the unit (E) such that it can be adjusted.

9. Method according to one of Claims 1 to 6, **characterized in that** the lowering of the gripper plane (GE) into the working position (AP) and/or into the focal plane (FE) is carried out by means of an electric motor controlled by a measuring system.

10. Manipulator for implementing the method according to one or more of Claims 1 to 9,
**characterized**
**in that** the optical system (OS) and the support of the gripper (GR) form a unit (E) which can be displaced in the pick-up and joining direction by means of the multi-coordinate positioning device,
**in that** the optical system (OS) has a fixed focal length (BW),
**in that** the gripper (GR) can be adjusted in the beam path between the optical system (OS) and its focal plane (FE) into a starting position (RP), a working position (AP) and a viewing position (BP) on the unit (E),
**in that**, in the starting position (RP), the gripper (GR) assumes an end position facing the optical system (OS) at a first large working distance from the focal plane (FE),
**in that** the working position (AP) lies between this end position and the focal plane (FE) and is sprung in the direction of the optical system (OS), and
**in that**, in the viewing position (BP), the gripper plane (GE) coincides with the focal plane (FE), the gripper (GR) being translucent, at least in the region of the beam path.

11. Manipulator according to Claim 10, **characterized in that** the gripper (GR) consists of glass or glass-clear plastic and is formed as a suction gripper.

12. Manipulator according to Claim 10 and 11, **characterized in that** the starting position (RP) and the viewing position (BP) are predefined by stops which belong to the unit (E) and which can preferably be displaced and locked.

13. Manipulator according to one of Claims 10 to 12, **characterized in that**, in the working position (AP), the gripper (GR) is sprung in the direction of the optical system (OS) by means of external springing (ÜF) in the unit (E) and can be deflected onto the gripper plane (GE) by means of pressure.

## Revendications

1. Procédé pour manipuler des composants à l'aide d'un système optique, d'une installation d'actionnement à coordonnées multiples et d'un manipulateur équipé d'une pince, procédé selon lequel
le système optique et la pince forment une unité actionnée par l'installation d'actionnement à coordonnées multiples et la pince est elle-même réglable en plus de cette unité,
**caractérisé en ce que**
le système optique (OS) de l'unité (E) a une focale fixe (BW),
la pince (GR) est installée entre le système optique (OS) et son plan focal (FE) et au début de l'opération de manipulation elle est réglée dans une position de travail (AP) dans laquelle son plan de préhension (GE) se trouve à une distance de travail du plan focal (FE),
l'unité (E) est déplacée dans la direction de réception et est allongée avec la pince (GR) en position de travail (AP) jusqu'à ce que le composant, qui doit être pris de son plan de réception, soit nettement visible dans le plan focal (FE) et puisse être pris,
l'unité (E) est ensuite déplacée en direction du plan de réception et la pince (GR) est placée sur le composant,
le composant est pris et l'unité (E) est soulevée dans la direction opposée à la direction de réception par rapport au plan de réception,
la pince (GR) est ainsi mise dans une position d'observation (BP) dans laquelle son plan de préhension (GE) coïncide avec le plan focal (FE),
et après mesure du composant en position d'observation (BP) on revient en position de travail (AP),
l'unité (E) est déplacée par-dessus la pièce et est positionnée sur la pièce à équiper, le plan focal (FE) étant mis en coïncidence avec le plan à équiper de la pièce et
l'assemblage du composant se fait de la même manière que la préhension du composant.

2. Procédé selon la revendication 1,
**caractérisé en ce qu'**
après assemblage du composant on ouvre la pince (GR) et on la reconduit de nouveau en position de travail (AP) pour un nouveau cycle de manipulation.

3. Procédé selon la revendication 1,
**caractérisé en ce que**
le système optique (OS) est équipé d'une caméra et d'une installation d'exploitation d'images.

4. Procédé selon l'une des revendications 1 à 3,
**caractérisé en ce que**
le composant pris par la pince (GR) est mesuré dans la position de l'unité (E) pour laquelle le plan de la préhension (GE) coïncide avec le plan focal (FE).

5. Procédé selon l'une des revendications 1 à 4,
**caractérisé en ce que**
la direction de prélèvement et celle d'assemblage sont de préférence alignées et sont situées suivant l'axe (z) de l'installation d'actionnement à coordonnées multiples.

6. Procédé selon l'une des revendications 1 à 5,
**caractérisé en ce que**
la pince (GR) est réglée dans une position de repos (RP) à partir de laquelle elle ne peut être déplacée qu'en direction du plan focal (FE).

7. Procédé selon l'une des revendications 1 à 6,
**caractérisé en ce que**
l'abaissement du plan de la préhension (GE) en position de travail (AP) et/ou dans le plan focal (FE) est limité par une butée.

8. Procédé selon la revendication 7,
**caractérisé en ce que**
la butée est montée de manière réglable sur l'unité (E).

9. Procédé selon la revendication 1 à 6,
**caractérisé en ce que**
l'abaissement du plan de préhension (GE) dans la position de travail (AP) et/ou dans le plan focal (FE) se fait à l'aide d'un moteur électrique commandé par un système de mesure.

10. Manipulateur pour la mise en oeuvre du procédé selon l'une ou plusieurs des revendications 1 à 9,
**caractérisé en ce que**
le système optique (OS) et le support de la pince (GR) forment une unité (E) réglable dans la direction de préhension et dans la direction d'assemblage par une installation d'actionnement à coordonnées multiples,
le système optique (OS) a une focale fixe (BW),
la pince (GR) est réglable entre le système optique (OS) et son plan focal (FE) dans une position de repos (RP), une position de travail (AP) et une position d'observation (BP) sur l'unité (E) dans le faisceau lumineux,
dans la position de repos (RP), la pince (GR) prend une position de fin de course tournée vers le système optique (OS) à une première distance de travail grande par rapport au plan focal (FE),
la position de travail (AP) est située entre cette position de fin de course et le plan focal (FE) et est suspendue élastiquement en direction du système optique (OS) et
en position d'observation (BP), le plan de préhension (GE) coïncide avec le plan focal (FE), la pince (GR) étant au moins transparente dans la zone du faisceau lumineux.

11. Manipulateur selon la revendication 10,
**caractérisé en ce que**
la pince (GR) est en verre ou en une matière plastique transparente comme du verre et la pince est réalisée comme une pince par aspiration.

12. Manipulateur selon les revendications 10 et 11,
**caractérisé en ce que**
la position de repos (RP) et la position d'observation (BP) sont prédéfinies de préférence par des butées de l'unité (E) qui peuvent être réglées et bloquées.

13. Manipulateur selon l'une des revendications 10 à 12,
**caractérisé en ce que**
la pince (GR) est suspendue élastiquement en position de travail (AP) à l'aide d'un ressort de suspension (ÛF), de manière excessive dans l'unité (E) en direction du système optique (OS) et peut être déviée vers le plan (GE) de la pince par la pression.
